# EUROPEAN PATENT APPLICATION

(11) **EP 1 074 638 A1**
(43) Date of publication of application: **07.02.2001**
(21) Application number: 99115327.1
(22) Date of filing: 03.08.1999
(51) Int. Cl.: C23C 14/08, C23C 14/00

(54) **Process for coating an article**

(71) Applicant: SIEMENS AKTIENGESELLSCHAFT, 80333 München (DE)
(72) Inventor: Döpper, Gebhard, 52066 Aachen (DE)

(57) **Abstract**

The invention relates to a process for coating an article of manufacture, which comprises the following steps:
introducing a body of the article of manufacture into a coating chamber;
establishing an atmosphere around the body in the coating chamber, the atmosphere containing an amount of noble gas having an atomic mass less than an atomic mass of argon; and
depositing a protective layer on the body for improving a lifetime of the article of manufacture subject to high-temperature exposure.

## Description

The invention relates to a process for coating an article of manufacture with a layer, in which the article of manufacture, in particular a component of a combustion machine, is disposed in a coating chamber.

U.S. Patent No. 5,238,752 describes a method for producing a thermal barrier layer system having an intermetallic adhesion coating for a small metallic component, in particular an aircraft engine blade having a length dimension of about 5 cm. The actual thermal insulation layer, made of zirconium oxide, is deposited on the component through the use of an electron-beam PVD (physical vapor deposition) method, with zirconium and yttrium oxide being evaporated from a metal-oxide body using an electron gun. The process is carried out in a device in which the component is heated to a temperature of about 950 °C to 1000 °C prior to the coating process. A heater is provided in the device for heating the component from above, if appropriate, in addition to heating due to the zirconium oxide to be deposited, and radiation emerging from the surface of the evaporating ceramic body. In order to deposit the zirconium oxide, a vacuum of about 7 x 10⁻³ Pa (7x10⁻⁵ mbar) is generated in the device, and a deposition rate of about 100 µm/h to 250 µm/h is achieved with the electron gun. The object of that operating set-up is to form a thermal barrier layer of zirconium oxide with a columnar grain microstructure on the all-metallic component.

U.S. Patent No. 4,676,994 describes a method for depositing a ceramic coating on a substrate that has a ceramic surface in that case, in which a first ceramic material is heated in a vacuum by an electron beam in such a way that it forms a sub-stoichiometric ceramic fluid. The substrate is heated in a vacuum to a temperature of above 900 °C and the first ceramic material is sub-stoichiometrically vacuum-evaporated thereon in order to form a dense ceramic layer. A layer of a ceramic with columnar orientation is deposited on that dense ceramic layer. During the vapor deposition of the sub-stoichiometric ceramic for producing the dense ceramic layer, the substrate temperature is maintained at a value between 900 °C and 1200 °C, and the vacuum pressure is preferably below 13 x 10⁻³ Pa. During the coating of the dense ceramic layer with the columnar ceramic layer there is an oxygen partial pressure between 0.060 Pa and 0.27 Pa, and the combined partial pressure of other gases is less than 10% of the total pressure. The method was, for example, carried out on a gas-turbine blade having a maximum length of 10 cm.

U.S. Patent Nos. 4,321,310 to Ulion et al.; and 4,321,311 to Strangman disclose coating systems for gas turbine components made from nickel or cobalt-based superalloys. A coating system described comprises a thermal barrier layer made from ceramic, which in particular has a columnar grained structure, placed on a bonding layer or bond coating which in its turn is placed on the substrate and bonds the thermal barrier layer to the substrate. The bonding layer is made from an alloy of the MCrAlY type, namely an alloy containing chromium, aluminum and a rare earth metal such as yttrium in a base comprising at least one of iron, cobalt and nickel. Further elements can also be present in a MCrAlY alloy. An important feature of the bonding layer is a thin layer developed on the MCrAlY alloy and used for anchoring the thermal barrier layer. That layer may be alumina or alumina mixed with chromia, depending on the composition of the MCrAlY alloy and the temperature of the oxidizing environment where the layer is developed.

It is an object of the invention to provide a process for coating an article of manufacture having a body, such as a component exposed to high temperature, which improves the heretofore-known methods of this general type and which achieves an improved forming of a layer, in particular a greater stability against cyclic thermal loading.

With the foregoing and other objects in view there is provided, in accordance with the invention, a process for coating an article of manufacture, which comprises the following steps: introducing a body of the article of manufacture into a coating chamber; establishing an atmosphere around the body in the coating chamber, the atmosphere containing an amount of noble gas having an atomic mass less than an atomic mass of argon; and depositing a protective layer on the body for improving a lifetime of the article of manufacture subject to high-temperature exposure.

High temperatures are defined in the context of the invention as temperatures above 500° C, and in particular above 800° C and more. Such high temperatures are established in most combustion processes and in the exhaust gases of such combustion processes, such as combustion processes in combustion turbines, combustion engines, such as those used in cars or other vehicles, or in furnaces. Components, e.g. bodies of articles of manufacture, of such machines and apparatus are regularly exposed to these high temperatures.

The basic feature of the invention resides in adding noble gas with an atomic mass less than argon to the atmosphere as an additional process gas which leads to a reduced influence of the process gases in the atmosphere. When using an inert gas which has a lower atomic weight than argon the influence of the process gas on collision processes that occur in the atmosphere is reduced, compared to a process gas having a atomic mass of argon or more. The atmosphere contains atoms or molecules of a material which forms the layer upon being deposited on the body or substrate of the article of manufacture the use of a light noble gas is most successful in reducing the kinetic energy of such atoms and molecules by collision with the process gases, especially the light noble gas. The loss in kinetic energy of the atoms and molecules which form the layer on the article of manufacture influences the formation of the layer and on the structure of the layer. As compared with collision processes that occur between process gases with a high weight and the atoms or molecules to be deposited the motion and the direction of motion of the atoms and molecules forming the layer prior to being deposited is not as much influenced by process gases having a lower mass.

In accordance with an additional mode of the invention the step of establishing the atmosphere comprises establishing the atmosphere with helium as the noble gas. Helium is a very light inert element so that even in the event a collision between the molecules or atoms forming the layer with the helium, the motion of such atoms and molecules is not appreciably changed in direction, yet a significant loss in kinetic energy occurs. This loss in kinetic energy leads to an improved structure of the layer. Neon could be used as an alternative to helium.

In accordance with another mode of the invention the establishing step comprises establishing the atmosphere with at least 5% by volume of the noble gas. Preferably the establishing step comprises establishing the atmosphere with at least 10% by volume of the noble gas. Such an amount of the noble gas already leads to a significant influence on the depositing process.

In accordance with a further mode of the invention the establishing step comprises establishing the atmosphere with an amount of oxygen. Preferably the atmosphere contains more than 80% by volume of oxygen. The oxygen is especially useful in a process in which an oxide layer is to be deposited. This ensures that enough oxygen is available to form the oxide layer on the article of manufacture.

In accordance with an added mode of the invention the depositing step comprises depositing a thermal barrier layer. Applying a thermal barrier layer leads to an improved heat resistance of the article of manufacture when exposed to high temperatures. High temperatures are those of above 500° C, and in particular above 800° C and more.

In accordance with an added mode of invention, the depositing step comprises depositing a layer, which consists essentially of a ceramic material.

In accordance with yet another mode of invention, the depositing step comprises depositing a layer comprising zirconia. Preferably the zirconia is partially stabilized by yttria. Other ceramic materials which are suitable to withstand high temperatures and to be deposited on the article of manufacture are of the spinel type, the perovskite type or the pyrochloric type.

In accordance with yet a further mode of the invention, the depositing step is a physical vapor deposition step, in particular an electron beam physical vapor deposition step.

In accordance with yet an added mode of the invention, the depositing step comprises depositing a thermal barrier layer on a component of a combustion turbine. Components of a combustion turbine are exposed to high temperatures up to 1200° C or even more. The material of the body or a substrate of the component must be heat insulated against direct contact with an exhaust gas of such a high temperature. A widely used material for the body of the component is a nickel or cobalt-based superalloy. A combustion turbine is preferably a stationary turbine used in an electrical energy producing power plant or in a factory plant for delivering process steam. A combustion turbine could also be an aircraft turbine or a turbine for ships. It is also possible to apply a thermal barrier layer on liner components of an oven or a furnace components, as well as on components of a combustion engine for cars or the like.

In accordance with a concomitant mode of the invention the depositing step comprises depositing a thermal barrier layer on a turbine vane, a turbine blade or a heat shield element of a combustion chamber or other components of a combustion turbine, such as a rotor part or the like.
- Fig. 1: is a schematic and diagrammatic view of a coating device;
- Fig. 2: is a sectional view of an annular combustion chamber of a combustion turbine;
- Fig. 3: is a fragmentary cross-sectional view of a substrate having a protective coating system incorporating a ceramic coating placed thereon; and
- Fig. 4: is a perspective view of a gas turbine airfoil component comprising the substrate and protective coating system shown in Fig. 3.

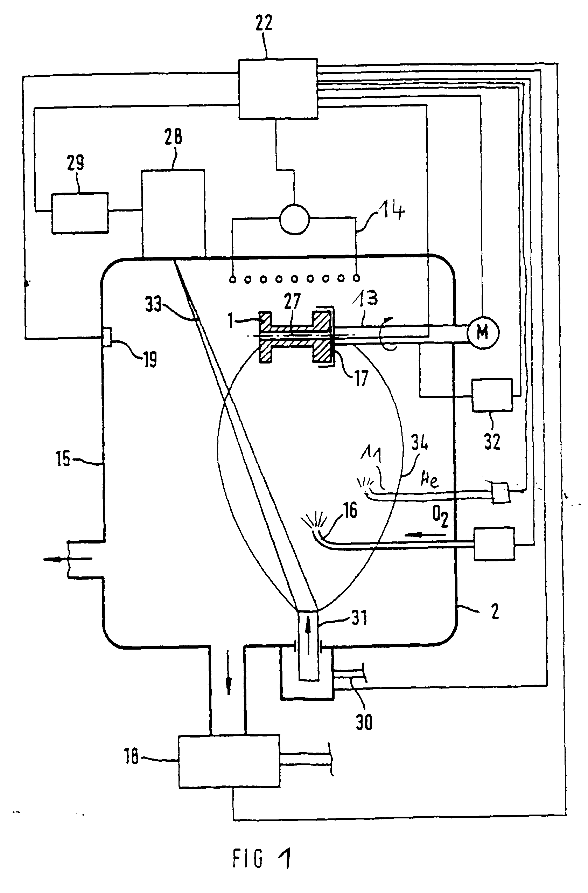

Referring now to the figures of the drawing in detail and first, particularly, to Fig. 1 thereof, there is seen a schematic and diagrammatic representation which is not to scale, of a coating device 15 for carrying out an electron-beam PVD method. The coating device has a coating chamber 12, in which a vacuum of below 10⁻² Pa can be produced by a vacuum-generating device 18, for example a vacuum pump. An electron gun 28 which is disposed outside the coating chamber 12 is connected to a power supply 29. A control device 22 is connected to a power supply 29. A forward feed or advancing device 30, which is disposed geodetically below the electron gun 28, moves a ceramic coating material 31 in rod or ingot form into the coating chamber 12. The forward feed device 30 is also connected to the control device 22. An article of manufacture as an exemplary embodiment has a body forming a component 1 of a gas turbine, diagrammatically represented as a gas turbine blade. In the following component and body are deemed to have the same meaning. The component 1 (body) is held geodetically above the forward feed device 30 in a holding device 13. The holding device 13 is connected to an auxiliary voltage supply 32 which is in turn connected to the control device 22. A DC voltage is applied between the auxiliary voltage supply 32 and the holding device 13, or more precisely the component 1. The DC voltage can be used to clean the surface of the component 1 by ionized inert gas atoms or the acceleration of atoms of the coating material onto the surface of the component 1. The holding device 13 preferably has a drive device, a motor M, which is connected to the control device 22. The drive device ensures continuous rotation of the component 1 about its longitudinal axis 27.

A feed 16 for reactive gas has an outlet region disposed geodetically above the forward feed device 30 and below the component 1. The feed 16 in this case is an oxidant feed, by which oxygen can be deliberately fed into the coating chamber 12 by the control device 22. Another feed 11 is provided in the coating chamber adjacent to the feed 16. The other feed 11 is used to feed noble gas, in particular helium, to the atmosphere installed in the coating chamber 12. Alternatively it is possible to have only one of the feeds 11 or 16 for providing a predefined mixture of reactive gas, such as oxygen, and inert gas, such as noble gas helium or neon. The control device 22 controls an atmosphere in the coating chamber 12. The atmosphere comprises over 80% by volume of oxygen and over 5 %, preferably over 10% by volume of helium (or another light noble gas, such as neon).

In order to heat the component 1, a heating device 14, which is likewise connected to the control device 22, is disposed geodetically above the component 1. The heating device 14 heats the component 1 by thermal radiation and/or convection. The heating device 14 is disposed geodetically above the component 1 and is also connected to the control device 22. It is understood that the heating device 14 may, if required, also be disposed on the same geodetic level next to the component 1. A vacuum-pressure measuring device 19, which is likewise connected to the control device 22, is furthermore provided in the coating chamber 12. At least one temperature sensor 17, for example a thermocouple, is disposed on the component 1 for detecting its component temperature or a component temperature distribution, and is likewise connected to the control device 22. The vacuum-generating device 18 is also connected to the control device 22.

In terms of process control, a complete coating process many be divided into the following steps:
a) setting up a component state before the coating (preheating to seeding temperature, reducing ambient pressure to coating pressure);
b) depositing a thermal barrier layer with requisite properties in terms of structure(for example columnar grain structure), adhesion and layer thickness (50 to 3000 µm); and
c) returning the component state to ambient conditions (room temperature and atmospheric air pressure).

The process for coating the article of manufacture, the component 1, is controlled by the control device 22 in a way that the relevant process and/or system parameters are controlled, corrected and adapted for the chronological running of the individual process steps, as for example disclosed in the international publication WO 97/46729 A1 of Hayess et al..

The required coating pressure and the gas atmosphere composition may simultaneously be adjusted in the coating chamber 12. The electron gun 28 produces an electron beam 33 during the coating process which is directed at the coating material 31 and evaporates the ceramic coating material. This being the case, the forward feed of the ceramic coating material 31 is adjusted by the forward feed device 30 and the power of the electron gun 28 through the power supply 29, to steady-state evaporation conditions.

Deliberate movement control of the component 1 (changing and maintaining the rotating speed) is applied for particularly favorable utilization of the coating material in a cloud 34 of coating material evaporated from the ceramic coating material 31. The steady-state feed of reactive gas (in particular 02) and inert gas (noble gas He) into the coating chamber 12 is set within a defined variation for the chamber atmosphere. The amount of helium in the chamber atmosphere of over 5%, preferably over 10%, by volume has a significant influence on the depositing process of evaporated ceramic material on the component 1. Ceramic material particles moving in the cloud 34 towards the component 1 collide with the process gas molecules or atoms (oxygen and helium). Due to the small mass of the helium, collisions with helium atoms lead to a reduction of kinetic energy of the ceramic material particles without significantly changing the direction of motion of these particles. This leads to an improved depositing process compared to such processes without an inert gas or with an inert gas such as argon with its high atomic weight.

After the coating has been completed, the coated body of the component 1 is cooled. Furthermore, a complete coating cycle, including a preheating process, the actual coating process and a cooling process, is coordinated in a predeterminable sequence by the control device 22. A corresponding control system includes suitable adjustment of the process parameters in the event of disturbances.

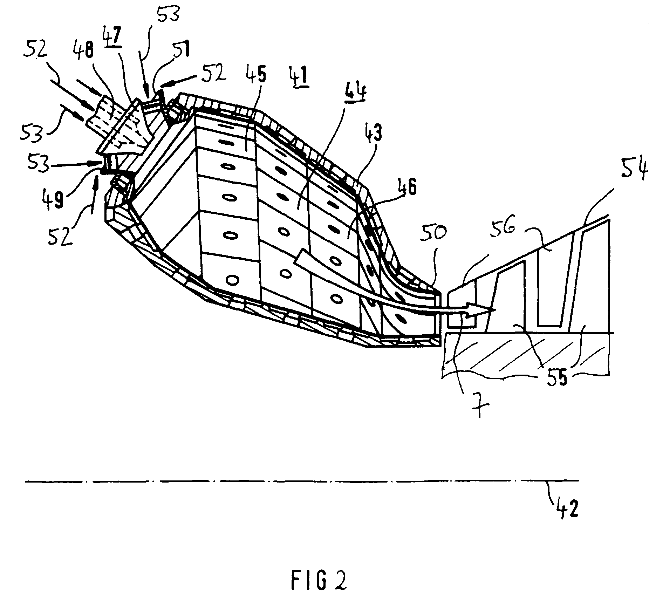

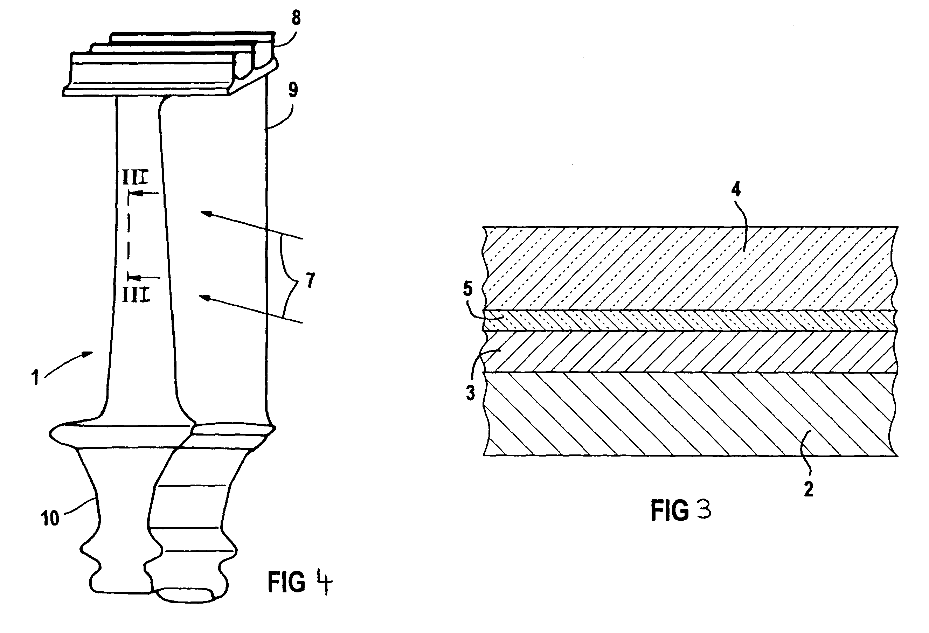

Referring now to Fig. 2, there is shown an annular combustion chamber 41 for a combustion turbine 54 in a sectional view. The annular combustion chamber 41 has a rotational axis 42. For reasons of simplicity only the upper half of the annular combustion chamber 41 is shown. The annular combustion chamber 41 has a chamber wall 43, which surrounds an annular space 44. The combustion wall 43 has an internal liner 35 with a plurality of heat shield elements 46. The heat shield elements 46 consist of a refractory ceramic or of a metallic plate, which is coated with a thermal barrier layer as shown in Fig. 3. In a burner end section 51 a burner system 47 is fixed to the combustion chamber 41. The burner system 47 has a diffusion burner 48 and a pre-mixing burner 49, which surrounds the diffusion burner 48 as a ring channel. Opposite the burner section 41, which forms an inlet of the combustion chamber 41, an outlet 50 for hot flue gas 7 opens to the turbine 54. Exiting the inlet 50 the hot flue gas 7 enters the combustion turbine 54 which comprises a turbine rotor 57 to which moving plates 55 are fixed. Stationary guide blades 56 are situated between adjacent moving plates 55.

During the operation of the combustion turbine 54 fuel 52 and air 53 are fed to the diffusion burner 48 which serves as a pilot burner. Furthermore fuel 52 and air 53 are also fed to the premixing burner 48. A stabilized flame on the diffusion burner 48 leads to an ignition of an air-fuel mixture burned in the premixing burner 49. Due to the combustion of the fuel 52 fed to the premixing burner 49 a hot exhaust gas (hot flue gas) flows through the combustion chamber 41 in the combustion turbine 54. This causes the moving blades 55 and the rotor 57 to rotate. The moving blade 55 and the guide blade 56 adjacent to the outlet 50 are coated with a thermal barrier coating system as shown in Fig. 3.

Referring now to Fig 3, there is seen a substrate 2 of a body 1 of an article of manufacture, in particular a gas turbine component 1, which in operation is subject to heavy thermal load, in particular to high temperatures over 500 oC, especially between 800 °C and up to 1200 °C or even more, and concurrently to corrosive and erosive attack. The substrate 2 is formed of a material which is suitable to provide strength and structural stability when subjected to a heavy thermal load and eventually an additional mechanical load by severe forces such as centrifugal forces. A material which is widely recognized and employed for such a purpose in a gas turbine is a nickel or cobalt-based superalloy.

In order to limit the thermal load imposed on the substrate 2, a thermal barrier layer 4 is deposited thereon. The thermal barrier layer 4 is made from a columnar grained ceramic, in particular consisting essentially of a stabilized or partly stabilized zirconia. The thermal barrier layer 4 preferably has a thickness of between 50 and 3000 µm. The thermal barrier layer 4 is anchored to the substrate 2 by means of an intermediate layer 3,5. The intermediate layer 3,5 is formed by depositing a bonding layer 3 on the substrate 2. The bonding layer 3 consists of an MCrAlY alloy and preferably of an MCrAlY alloy as disclosed in one of U.S. Patents 5,154,885; 5,268,238; 5,273,712; and 5,401,307, and developing an anchoring layer 5 on the bonding layer 3, as explained subsequently. The bonding layer 3 has in particular the function to create a tight bond to the substrate 2. The anchoring layer 5 serves as an anchor for the thermal barrier layer 4. The anchoring layer 5 essentially consists of an oxide compound, namely alumina. Both the bonding layer 3 and the anchoring layer 5 form the intermediate layer.

The drawing is not intended to show the thicknesses of the layers 3 and 5 to scale; the thickness of the anchoring layer 5 might in reality be very much less than the thickness of the bonding layer 3. The thickness of the later might be several µm, for example 0,5 to 10 µm and the thickness of the former amount only to a few atomic layers, as specified hereinabove.

The anchoring layer 5 can be made by several methods, in particular by a physical vapor deposition process like electron beam PVD, sputter ion plating and cathodic arc-PVD, or by thermal treatment of the bonding layer 3 in a oxygen atmosphere. Such thermal treatment is in particular carried out at a temperature within a range between 700 °C and 1100 °C.

Fig. 4 shows the complete gas turbine component, namely a gas turbine airfoil component 1, in particular a turbine blade. The section of Fig. 3 is taken along the line III-III in Fig. 4. The component 1 has an airfoil portion 9, which in operation forms an "active part" of the gas turbine engine, a mounting portion 10, at which the component 1 is fixedly held in its place, and a sealing portion 8, which forms a seal together with adjacent sealing portions of neighboring components to prevent an escape of a hot gas stream 7 flowing along the airfoil portion 9 during operation.

That thermal barrier layer 4 may expediently be deposited on the substrate 2 immediately after deposition or thermally grown of the anchoring layer 5 and in particular within the same apparatus and by using as much as possible installations which have been already in use for depositing the anchoring layer 5. The combination of the anchoring layer 5 and the thermal barrier layer 4 thus made has all the advantages of such combinations known from the related art.

## Claims

1. A process for coating an article of manufacture, which comprises the following steps:
introducing a body of the article of manufacture into a coating chamber;
establishing an atmosphere around the body in the coating chamber, the atmosphere containing an amount of noble gas having an atomic mass less than an atomic mass of argon; and
depositing a protective layer on the body for improving a lifetime of the article of manufacture subject to high-temperature exposure.

2. The process according to claim 1, wherein the establishing step comprises establishing the atmosphere with helium as the noble gas.

3. The process according to claim 1, wherein the establishing step comprises establishing the atmosphere with at least 5 % by volume of the noble gas.

4. The process according to claim 3, wherein the establishing step comprises establishing the atmosphere with at least 10 % by volume of the noble gas.

5. The process according to claim 1, wherein the establishing step comprises establishing the atmosphere with an amount of oxygen.

6. The process according to claim 1, wherein the establishing step comprises establishing the atmosphere with more than 80 % oxygen by volume.

7. The process according to claim 1, wherein the depositing step comprises depositing a thermal barrier layer.

8. The process according to claim 1, wherein the depositing step comprises depositing a layer consisting essentially of a ceramic material.

9. The process according to claim 1, wherein the depositing step comprises depositing a layer comprising zirconia.

10. The process according to claim 9, wherein the depositing step comprises depositing the layer which is partially stabilized by yttria.

11. The process according to claim 1, wherein the depositing step is a physical vapor deposition step.

12. The process according to claim 11, wherein the depositing step is an electron beam physical vapor deposition step.

13. The process according to claim 1, wherein the depositing step comprises depositing a thermal barrier layer on a component of a combustion turbine.

14. The process according to claim 1, wherein the depositing step comprises depositing a thermal barrier layer on a turbine vane.

15. The process according to claim 1, wherein the depositing step comprises depositing a thermal barrier layer on a turbine blade.

16. The process according to claim 1, wherein the depositing step comprises depositing a thermal barrier layer on a heat shield element of a combustor.
